# EUROPEAN PATENT APPLICATION

(11) **EP 3 076 547 A1**
(43) Date of publication of application: **05.10.2016**
(21) Application number: 15305459.8
(22) Date of filing: 30.03.2015
(51) Int. Cl.: H03F 3/217, H03M 3/00

(54) **A METHOD FOR GENERATION OF A PULSE PATTERN, AND A TRANSMITTER THEREFOR**

(71) Applicant: ALCATEL LUCENT, 92100 Boulogne-Billancourt (FR)
(72) Inventor: Haslach, Christoph, 70435 Stuttgart (DE); Markert, Daniel, 70435 Stuttgart (DE)
(74) Representative: Kleinbub, Oliver

(57) **Abstract**

The invention concerns a method for pulse pattern generation, wherein an input signal is duplicated into a first and a second input signal part, a delta sigma modulation of the first input signal part is performed resulting in a first modulated input signal part, a first pulse pattern part is generated from the first modulated input signal part, the second input signal part is multiplied with a factor resulting in a multiplied second input signal part, a delta sigma modulation of the multiplied second input signal part is performed resulting in a second modulated input signal part, a multiplied second pulse pattern part is generated from the second modulated input signal part by multiplication with the inverted factor, and the first pulse pattern part and the multiplied second pulse pattern part are added, and a transmitter therefor.

## Description

### Field of the invention

The invention relates to a method for generation of a pulse pattern using delta sigma modulation, and a transmitter adapted to perform said method.

### Background

Switch mode power amplifiers (SMPA) are promising approaches for future highly efficient and highly flexible transmitter and amplifier solutions used e.g. in wireless communication networks. A key issue in this context is the switch mode signal generation. An essential part of the SMPA approach is the so-called switch mode modulator (SMM). Due to cost and efficiency reasons it is desirable to have a digital solution for the switch mode modulator (SMM). Thus, in order to support highly efficient switch mode power amplifiers, signals with continuous amplitude, or multi-level signals, need to be converted to signals with fewer levels, as e.g. 2-level signals. This transformation is e.g. executed by so-called delta sigma modulators (DSM), also called sigma delta modulators.

### Summary

A critical bottleneck for all the digital concepts are signal distortions caused by an effect which is caused due to phase modulation of the wanted signal and/or if incoming so-called IQ samples represent a signal that provides a frequency offset related to the nominal carrier frequency fc. This leads to significant spectral distortions that severely limit the application of these approaches for future product applications.

The object of the invention is thus to propose a flexible and effective method to compensate said distortions with only moderate or low complexity.

There are some approaches to overcome or to tame this problem, but they all suffer either from high complexity, high calibration effort, significant hardware effort or limited performance.

Existing solutions to overcome said problem are as follows:
- Asynchronous resampling of input data: This solution goes along with a very high computational effort, and furthermore a post-processing of the data is required.
- Digital predistortion (DPD): This solution goes along with addition hardware effort, and high effort to calibrate and model the impairments.
- Feedforward Compensation: This solution goes along with high additional hardware effort.

An approach which is common to many state of the art digital switch mode modulators (SMM) is the combination of a delta sigma modulator (DSM) with a pulse pattern generator. The delta sigma modulator provides the quantization of the input signal and the pulse pattern generator generates a binary or multi-level pulse pattern. For each output value candidate of the delta sigma modulator one pulse pattern of a certain length is generated.

A basic idea of embodiments of the invention is now to employ a second delta sigma modulator and a second pulse pattern generator. The second delta sigma modulator is fed by the same input values as the first delta sigma modulator, but additionally, the input values will be multiplied by a factor, preferably by a factor -1, i.e. the input values will preferably be inverted. The input values may also be multiplied by another complex factor, but -1 is a good choice for reducing the above-mentioned spectral distortions and is probably the best choice for many constellations. By feeding the second delta sigma modulator with the inverted signal and inverting the second pulse pattern generator output again, the wanted carrier signal is inverted twice which is equivalent to no inversion for the wanted signal. However, as already mentioned above, in a more general embodiment of the invention, the input values of the second delta sigma modulator are multiplied by an arbitrary complex factor, and the second pulse pattern generator output values are multiplied with the inverted complex factor, which is equivalent to no inversion for the wanted signal.

It has been empirically verified that many distortions created in a delta sigma modulator are not inverted by inverting the input signal. This means that adding the output values of both delta sigma modulators allows to sum up the wanted signal constructively, whereas the distortions which are not inverted by the second delta sigma modulator are combined destructively due to the fact that there is a second inverter after the second pulse pattern generator, i.e. the second delta sigma modulator.

The object is thus achieved by a method for generation of a pulse pattern using delta sigma modulation, wherein
- an input signal is duplicated into a first and a second input signal part,
- a first delta sigma modulation of the first input signal part is performed resulting in a first modulated input signal part,
- a first pulse pattern part is generated from the first modulated input signal part,
- the second input signal part is multiplied with a factor resulting in a multiplied second input signal part,
- a second delta sigma modulation of the multiplied second input signal part is performed resulting in a second modulated input signal part,
- a multiplied second pulse pattern part is generated from the second modulated input signal part by multiplication with the inverted factor,
- and the first pulse pattern part and the multiplied second pulse pattern part are added resulting in the pulse pattern.

The object is furthermore achieved by a transmitter for generation of a pulse pattern using delta sigma modulation, wherein said transmitter is operable to
- duplicate an input signal into a first and a second input signal part in a splitting module,
- perform a first delta sigma modulation of the first input signal part in a first delta sigma modulator resulting in a first modulated input signal part,
- generate a first pulse pattern part in a first pulse pattern generator from the first modulated input signal part,
- multiply the second input signal part with a factor in a first multiplication module resulting in a multiplied second input signal part,
- perform a second delta sigma modulation of the multiplied second input signal part in a second delta sigma modulator resulting in a second modulated input signal part,
- generate a second pulse pattern part or a multiplied second pulse pattern part in a second pulse pattern generator from the second modulated input signal part or from a multiplied second modulated input signal part,
- multiply the second pulse pattern part or the second modulated input signal part with the inverted factor in a second multiplication module resulting in a multiplied second pulse pattern part or in the multiplied second modulated input signal part,
- and add the first pulse pattern part and the multiplied second pulse pattern part resulting in the pulse pattern.

In an embodiment of the invention, said factor the second input signal part is multiplied with in the first multiplication module is equal to -1. Thus, the second input signal part is inverted in the first multiplication module.

In an embodiment of the invention, said factor the second input signal part is multiplied with in the first multiplication module is a complex factor. After delta sigma modulation of the multiplied second input signal part in the second delta sigma modulator and after the second pulse pattern part is generated in a second pulse pattern generator from the second modulated input signal part, the second pulse pattern part is multiplied with the inverted complex factor which is equivalent to no inversion for the wanted signal.

In an embodiment of the invention, said first and second pulse pattern parts are binary pulse patterns, which are particularly suitable as input signals for switch mode power amplifiers.

In an embodiment of the invention, said first and second pulse pattern parts are multi-level pulse patterns, which have a higher coding efficiency than binary pulse patterns.

In an embodiment of the invention, the first pulse pattern part is generated dependent on a first sum of trigger impulses generated in a summing time interval of the first delta sigma modulation, and the second pulse pattern part is generated dependent on a second sum of trigger impulses generated in a summing time interval of the second delta sigma modulation. The first and second pulse patterns can have a dedicated number of pulses dependent on the first and second sum of trigger impulses. In addition or alternatively, the levels of the pulses can be chosen dependent on the first and second sum of trigger impulses. Also in addition or alternatively, the width of the pulses can be chosen dependent on the first and second sum of trigger impulses.

In an embodiment of the invention, the pulse pattern is fed to a switch mode power amplifier.

In an embodiment of the invention, the first pulse pattern part is fed to a first switch mode power amplifier, and the multiplied second pulse pattern part is fed to a second switch mode power amplifier.

Further features and advantages are stated in the following description of exemplary embodiments, with reference to the figures, which shows significant details, and are defined by the claims. The individual features can be implemented individually by themselves, or several of them can be implemented in any desired combination.

### Brief description of the figures

In the following the invention will be explained further making reference to the attached drawings.
Fig. 1 schematically shows a transmitter for generation of a pulse pattern using delta sigma modulation applying two delta sigma modulators and two pulse pattern generators according to an embodiment of the invention.
Fig. 2 schematically shows a transmitter for generation of an amplified pulse pattern using delta sigma modulation applying two delta sigma modulators, two pulse pattern generators and two switch mode power amplifiers according to an embodiment of the invention.
Fig. 3 schematically shows a transmitter for generation of an amplified pulse pattern using delta sigma modulation applying two delta sigma modulators, two pulse pattern generators and a switch mode power amplifier according to an embodiment of the invention.
Fig. 4 schematically shows a comparison of the adjacent channel power leakage ratio (ACLR) of pulse patterns generated according to two state of the art methods, the so-called single/double path methods with a method according to an embodiment of the invention, the so-called double inverted method.

### Description of the embodiments

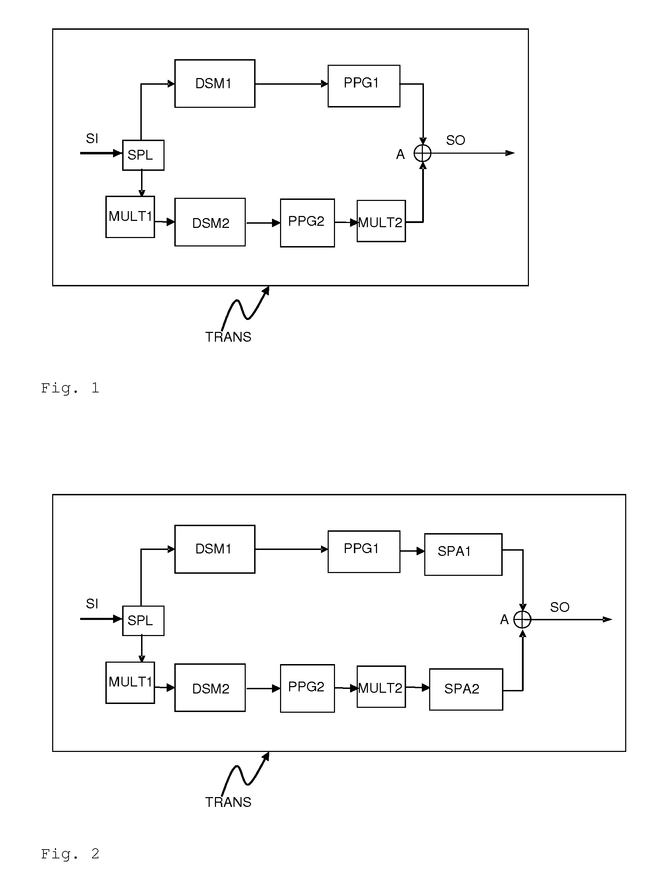

Fig. 1 schematically shows a transmitter for generation of a pulse pattern using delta sigma modulation applying two delta sigma modulators and two pulse pattern generators according to an embodiment of the invention.

Depending on the implementation, the input signal SI of the transmitter TRANS can either be a signal with continuous amplitude, or the sampled version of the continuous amplitude signal, sampled at equidistant time instances.

The input signal SI is fed to a splitting module SPL in which the input signal SI is split, i.e. duplicated into a first and a second input signal part.

The first input signal part is fed to an input of a first delta sigma modulator DSM1, in which the first input signal part is transformed into a sum of trigger delta impulses for a predefined summing interval.

The sum of trigger delta impulses is fed to an input of a first pulse pattern generator PPG1, and a binary or multi-level first pulse pattern part is generated. For each output value candidate of the first delta sigma modulator DSM1, i.e. for each candidate value for the sum of trigger delta impulses one first pulse pattern part of a certain length is generated.

The first pulse pattern part is then fed to a first input of an adder A.

The second input signal part is fed to an input of a first multiplication module MULT1, in which the second input signal part is multiplied with a factor resulting in a multiplied second input signal part.

The multiplied second input signal part is then fed to an input of a second delta sigma modulator DSM2, in which the multiplied second input signal part is transformed into a sum of trigger delta impulses for a predefined summing interval.

The sum of trigger delta impulses is fed to an input of a second pulse pattern generator PPG2, and a binary or multi-level second pulse pattern part is generated. For each output value candidate of the second delta sigma modulator DSM2, i.e. for each candidate value for the sum of trigger delta impulses one second pulse pattern part of a certain length is generated.

The second pulse pattern part is then fed to an input of a second multiplication module MULT2, in which the second pulse pattern part is multiplied with the inverted factor resulting in a multiplied second pulse pattern part.

The multiplied second pulse pattern part is then fed to a second input of the adder A.

The first pulse pattern part and the multiplied second pulse pattern part are added in the adder A resulting in a wanted pulse pattern SO as output of the transmitter TRANS. After combining the first pulse pattern part and the multiplied second pulse pattern part, the signal alphabet increases from {0,1}, i.e. binary, to {-1,0,1}, i.e. duobinary or ternary.

As already mentioned above, using such a transmitter as depicted in fig. 1 and described above leads to a reduction of signal distortions caused by an effect which is caused due to phase modulation of the wanted signal and/or if incoming so-called IQ samples represent a signal that provides a frequency offset related to the nominal carrier frequency fc.

This is due to the fact, that many distortions created in the second delta sigma modulator DSM2 are not inverted by inverting the second input signal part in the first multiplication module MULT1. This means that adding the output values of the first pulse pattern generator PPG1 and the second multiplication module MULT2 allows to sum up the wanted signal constructively, whereas the distortions which are not inverted by the second delta sigma modulator DSM2 are combined destructively due to the fact that there is a second inversion performed in the second multiplication module MULT2 after the second pulse pattern generator PPG2, i.e. after the second delta sigma modulator DSM2.

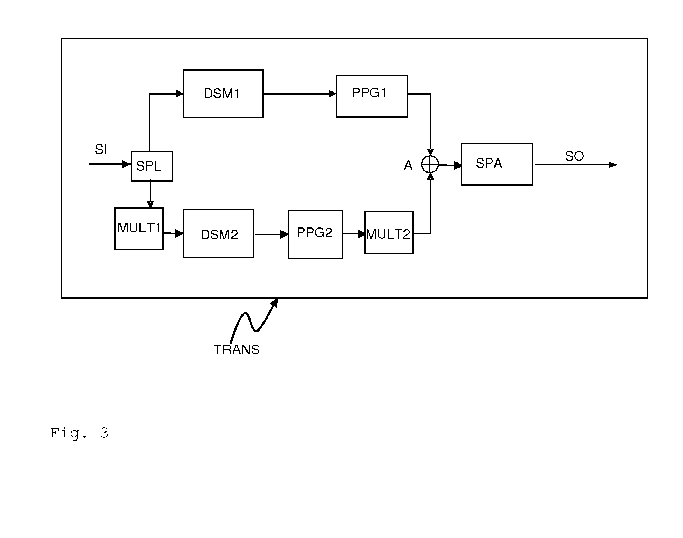

The pulse pattern SO, or the first and second pulse pattern parts of the first and second pulse pattern generators PPG1 and PPG2 can be used as input signal of switch mode amplifiers. Such a signal amplification can e.g. be used in a wireless communication network for amplification of radio signals for transmission over an air interface. Embodiments of the invention applying switch mode amplifiers are depicted in figs. 2 and 3, and will be described in the following.

Fig. 2 schematically shows a transmitter for generation of an amplified pulse pattern using delta sigma modulation applying two delta sigma modulators, two pulse pattern generators and two switch mode power amplifiers according to an embodiment of the invention.

As the embodiment in fig. 2 in principle corresponds to the embodiment depicted in fig. 1, only the differences are described in the following.

The generation of the first pulse pattern part and the multiplied second pulse pattern part is performed as depicted in fig. 1 and described above.

However, instead of adding the first pulse pattern part and the multiplied second pulse pattern part in the adder A as depicted in fig. 1 and described above, in the embodiment depicted in fig. 2, the first pulse pattern part is fed to an input of a first switch mode power amplifier SPA1 resulting in an amplified first pulse pattern part, and the multiplied second pulse pattern part is fed to an input of a second switch mode power amplifier SPA2 resulting in an amplified second pulse pattern part. The amplified first pulse pattern part, and the amplified second pulse pattern part are in turn added in the adder A resulting in a wanted pulse pattern SO as output of the transmitter TRANS.

Fig. 3 schematically shows a transmitter for generation of an amplified pulse pattern using delta sigma modulation applying two delta sigma modulators, two pulse pattern generators and a switch mode power amplifier according to an embodiment of the invention.

As the embodiment in fig. 2 in principle corresponds to the embodiment depicted in fig. 1, only the differences are described in the following.

The generation of the first pulse pattern part and the multiplied second pulse pattern part is performed as depicted in fig. 1 and described above. Also adding of the first pulse pattern part and the multiplied second pulse pattern part in the adder A is performed as depicted in fig. 1 and described above.

However, instead of directly outputting the added first pulse pattern part and multiplied second pulse pattern part as the pulse pattern SO from the transmitter TRANS, in the embodiment depicted in fig. 3, the added first pulse pattern part and multiplied second pulse pattern part is fed to an input of a switch mode power amplifier SPA resulting in an amplified pulse pattern SO as output of the transmitter TRANS.

For performing a complex multiplication with a complex number in the second pulse pattern generator PPG2 depicted in the embodiments in figs. 1 to 3 and described above, the absolute value of the complex number corresponds to a change of the pulse amplitude or the pulse width. Alternatively, the phase of the complex number corresponds to a change of the pulse center or a cyclic rotation of the single pulse sequences.

In the embodiments depicted in figs. 1 to 3 and described above, the output of the second delta sigma modulator DSM2 is connected to the second pulse pattern generator PPG2, and then to the second multiplication module MULT2. However, in alternatives of the above-described embodiments, the order of the second delta sigma modulator DSM2 and the second pulse pattern generator PPG2 can also be exchanged, i.e. the multiplication can be performed before the pulse pattern generation. In this case, the second delta sigma modulator DSM2 e.g. provides a quantized complex so-called IQ signal for describing pulses, which will be multiplied with a factor *e^{-iπ},* which results in an inversion of the pulse pattern. Generally, the second delta sigma modulator DSM2 can in said alternative embodiments also provide an index which describes the pulse pattern that has to be generated. The second delta sigma modulator DSM2 can in said alternative embodiments perform multiplications by mapping the index provided by the second delta sigma modulator DSM2 to a further index by means of a table.

In order to verify whether spectral purity, e.g. indicated by so-called adjacent channel power leakage ratio (ACLR), is improved by a method according to an embodiment of the invention for generation of pulse patterns over a wide range of frequency offsets, simulations of ACLR for two methods for pulse pattern generation according to the state of the art have been compared with a method for pulse pattern generation according to an embodiment of the invention.

The following parameters have been used for simulations of ACLR for two methods for pulse pattern generation according to the state of the art, and a method for pulse pattern generation according to an embodiment of the invention:
- carrier frequency: a 2GHz carrier frequency is used.
- test signal: a 20MHz LTE signal, with a crest factor of ∼6dB is used.
- delta sigma modulation: a 4^{th} order delta sigma modulation for a 2GHz carrier frequency is used.
- pulse pattern generation: a binary pulse width modulation pattern generator is used, generating all bit patterns with a duty cycle <= 50%, including all cyclically shifted patterns to each output value of the delta sigma modulator. A 32bit sequence is generated by the pulse pattern generator.

The delta sigma modulator is fed with a complex valued so-called IQ sample as test signal.

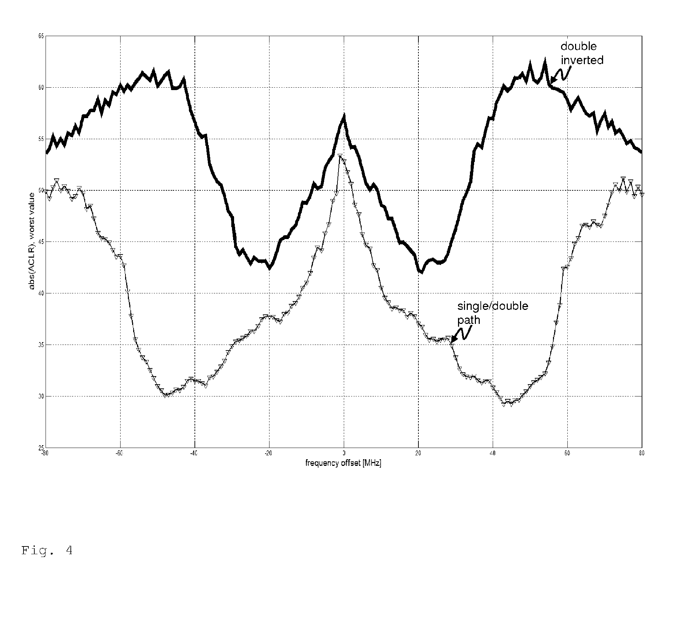

Fig. 4 schematically shows such a comparison of the adjacent channel power leakage ratio (ACLR) of pulse patterns generated according to two state of the art methods with a method according to an embodiment of the invention. The ACLR values are depicted over the frequency offset with respect to the carrier frequency.

For determination of the ACLR, the signals are scaled, i.e. normalized, so that all setups provide identical overall mean output signal power. For depicting the ACLR values, the worst of the so-called ACLR1 value, which is the ACLR value with respect to the next channel, on the lower and upper frequency side, and of the so-called ACLR2 value, which is the ACLR value with respect to the overnext channel, on the lower and upper frequency side are depicted versus the frequency shift relative to the carrier frequency fc.

The ACLR diagram related to the embodiment of the invention is denoted with "double inverted" in fig. 4, and is deduced from the pulse pattern SO generated by the transmitter depicted in fig. 1.

The two ACLR diagrams related to the two methods for pulse pattern generation according to the state of the art are denoted with "single/double path" and are undistinguishable due to the fact that they fully coincide.

The first method according to the state of the art is related to a conventional setup with a single path comprising a single digital delta sigma modulator and single pulse pattern generator.

The second method according to the state of the art is related to a conventional setup in which the output of a signal path comprising a single digital delta sigma modulator and single pulse pattern generator is split, i.e. duplicated in a first and second part, the first part is delayed by 1/fc/2, with fc being the carrier frequency, then inverted and added to the second part. Such a conventional delay-invert-combine principle, e.g. described in the patent application EP 12305599.8, which is often applied to convert a binary pulse width modulation signal into a ternary one, provides no benefit near the carrier signal, e.g. provides no improvement of ACLR, as it has only impact on the wideband spectrum, as e.g. on the wideband coding efficiency.

From the comparison of the diagrams in fig. 4, it can be seen that depending on the frequency offset an ACLR improvement by 6-30 dB can be achieved by applying the method according to the embodiment of the invention for generation of pulse patterns as depicted in fig. 1. The method according to the invention provides significant improvements for larger frequency offsets. For small frequency offset the benefits decrease, but still remain in the range of several dB.

As an example for an application of a transmitter according to the invention, a base station in a wireless communication network can comprise a transmitter according to one of the embodiments described above, and an antenna network for transmission of signals over an air interface.

## Claims

1. A method for generation of a pulse pattern (SO) using delta sigma modulation, wherein
• an input signal (SI) is duplicated into a first and a second input signal part,
• a first delta sigma modulation of the first input signal part is performed resulting in a first modulated input signal part,
• a first pulse pattern part is generated from the first modulated input signal part,
• the second input signal part is multiplied with a factor resulting in a multiplied second input signal part,
• a second delta sigma modulation of the multiplied second input signal part is performed resulting in a second modulated input signal part,
• a multiplied second pulse pattern part is generated from the second modulated input signal part by multiplication with the inverted factor,
• and the first pulse pattern part and the multiplied second pulse pattern part are added resulting in the pulse pattern (SO).

2. A method according to claim 1, wherein said factor is a complex factor.

3. A method according to claim 1, wherein said factor is -1.

4. A method according to any of the preceding claims, wherein said first and second pulse pattern parts are binary pulse patterns.

5. A method according to claim 1, 2 or 3, wherein said first and second pulse pattern parts are multi-level pulse patterns.

6. A method according to any of the preceding claims, wherein the first pulse pattern part is generated dependent on a first sum of trigger impulses generated in a summing time interval of the first delta sigma modulation, and the second pulse pattern part is generated dependent on a second sum of trigger impulses generated in a summing time interval of the second delta sigma modulation.

7. A method according to claim 1, wherein the pulse pattern (SO) is fed to a switch mode power amplifier.

8. A transmitter (TRANS) for generation of a pulse pattern (SO) using delta sigma modulation, wherein said transmitter (TRANS) is operable to
• duplicate an input signal (SI) into a first and a second input signal part in a splitting module (SPL),
• perform a first delta sigma modulation of the first input signal part in a first delta sigma modulator (DSM1) resulting in a first modulated input signal part,
• generate a first pulse pattern part in a first pulse pattern generator (PPG1) from the first modulated input signal part,
• multiply the second input signal part with a factor in a first multiplication module (MULT1) resulting in a multiplied second input signal part,
• perform a second delta sigma modulation of the multiplied second input signal part in a second delta sigma modulator (DSM2) resulting in a second modulated input signal part,
• generate a second pulse pattern part or a multiplied second pulse pattern part in a second pulse pattern generator (PPG2) from the second modulated input signal part or from a multiplied second modulated input signal part,
• multiply the second pulse pattern part or the second modulated input signal part with the inverted factor in a second multiplication module (MULT2) resulting in a multiplied second pulse pattern part or in the multiplied second modulated input signal part,
• and add the first pulse pattern part and the multiplied second pulse pattern part resulting in the pulse pattern (SO).

9. A transmitter (TRANS) according to claim 8, comprising a switch mode power amplifier (SPA) for signal amplification using the pulse pattern (SO) as input signal.

10. A transmitter (TRANS) according to claim 8, comprising a first switch mode power amplifier (SPA1) for signal amplification using the first pulse pattern part, and comprising a second switch mode power amplifier (SPA2) for signal amplification using the multiplied second pulse pattern part as input signal.

11. A base station comprising a transmitter (TRANS) according to claim 8 or 9 and at least one antenna network for transmission of signals over an air interface.
